# EUROPÄISCHE PATENTSCHRIFT

(11) **EP 1 772 045 B1**
(45) Veröffentlichungstag und Bekanntmachung des Hinweises auf die Patenterteilung: **27.02.2008**
(21) Anmeldenummer: 05823478.2
(22) Anmeldetag: 19.12.2005
(51) Int. Cl.: H05K 13/00

(54) **POSITIONIEREINRICHTUNG MIT EINER LINEAR VERSCHIEBBAREN POSITIONIEREINHEIT**
POSITIONING DEVICE PROVIDED WITH A LINEARLY DISPLACEABLE POSITIONING UNIT
DISPOSITIF DE POSITIONNEMENT POURVU D'UNE UNITE DE POSITIONNEMENT A DEPLACEMENT LINEAIRE

(30) Priorität: 01.02.2005 DE 102005004618
(43) Veröffentlichungstag der Anmeldung: 11.04.2007
(73) Patentinhaber: Siemens Aktiengesellschaft, 80333 München (DE)
(72) Erfinder: KÖHLER, Ulrich, 82031 Grünwald (DE)
(86) Internationale Anmeldenummer: PCT/EP2005/056927
(87) Internationale Veröffentlichungsnummer: WO 2006/081900

(56) Entgegenhaltungen:
- EP-A1- 0 940 229
- US-A- 4 637 738
- US-A- 5 002 448
- US-B1- 6 246 203

## Beschreibung

Die Erfindung bezieht sich auf eine Positioniereinrichtung, insbesondere zum Handhaben von elektrischen Bauelementen, mit zwei parallelen, eine Führungsebene definierenden Führungsbahnen und daran linear verschiebbar geführten Lagern, an denen eine Positioniereinheit verankert ist.

Durch die EP0962125 B1 ist ein einseitig geführter und angetriebener länglicher Positionierarm bekannt, bei dem das gegenüberliegende freiragende Ende ungedämpft schwingen kann, so dass ein entsprechender hochdynamischer Positioniervorgang um die Ausschwingzeit verzögert wird. Der Positionierarm benötigt zumindest 3 Lager- bzw. Stützelemente. Um das Nachschwingen zu reduzieren, muss ein solcher Positionierarm möglichst biegesteif ausgebildet werden, was seine Eigenmasse vergrößert bei den geforderten Beschleunigungen die Antriebs- bzw. Bremsleistung erhöht.

Durch die US5002448 A ist ein beidseitig geführter Positionierarm bekannt, bei dem eine Verbindungsachse zwischen den beidseitig angeordneten Führungslagern senkrecht zur Führungsbahn verläuft. Bereits geringe, auch thermisch bedingte Abstandsabweichungen zwischen den Führungsbahnen bewirken zwischen den einander starr zugeordneten Führungslagern erhebliche verschleißsteigernde Verspannungen. Das nicht angetriebene Ende kann ungehindert nachschwingen.

Um diese zu verringern sind bei einem weiteren Positionierarm nach der EP940229 A1 zwischen den Lagerelementen und dem Positionierarm elastische Ausgleichselemente vorgesehen, die die Positioniergenauigkeit beeinträchtigen und das Schwingungsverhalten versschlechtern.

Der Erfindung liegt die Aufgabe zugrunde, mit geringem Herstellungsaufwand eine schwingungsarme verspannungsfreie Positioniereinrichtung zu schaffen.

Diese Aufgabe wird durch die Erfindung gemäß Anspruch 1 gelöst. Die Schrägstellung der Verbindungsachse wird z.B. dadurch erreicht, dass sie länger ist als der orthogonale Abstand zwischen den zu den Führungsbahnen parallel verlaufenden Verschiebebahnen der Gelenkachsen, die z.B. unmittelbar neben oder über den Führungsbahnen angeordnet sein können. Die entsprechenden Gelenke können z.B. scharnierartig ausgebildet sein und ermöglichen im Hinblick auf die Winkellage eine Entkopplung der Lager vom der Positioniereinheit. Dadurch richten sich die Lager in ihrer Orientierung selbsttätig genau an den Führungsbahnen aus, so dass eine genaue gegenseitige Anpassung der Führungsbahnen und der Verschiebeteile nicht erforderlich ist und der Herstellungsaufwand entsprechend verringert werden kann.

Die erfindungsgemäße Positioniereinrichtung benötigt nur zwei Lager, die eine definierte 2-Punkt-Führung des Positionierarms ermöglichen. Die Neigung der Verbindungsachse zwischen den Lagerelementen passt sich den jeweiligen geometrischen Verhältnissen mühelos an, so dass bei einem hinreichenden Neigungswinkel Verspannungen zwischen den Führungselementen sicher vermieden werden. Da durch die schräge Anlenkung auch das nicht angetriebene Ende gegen Auslenkung in der Verschieberichtung gesichert ist, wird beim Positionierarm das Nachschwingen weitgehend verhindert. Der Positionierarm kann wegen der beidseitigen Abstützung schlank und leicht ausgebildet werden, so dass die zu beschleunigende Masse gegenüber einem einseitig eingespannten Positionierarm deutlich verringert werden kann.

Vorteilhafte Weiterbildungen der Erfindung sind in den Ansprüchen 2 bis 17 gekennzeichnet:

Da die Führungsbahnen mit geringen Lageabweichungen angeordnet werden können, können die entsprechenden Winkeländerungen zwischen der Verbindungsachse und den Führungsbahnen sehr klein gehalten und über die Festkörpergelenke nach Anspruch 2 ausgeglichen werden.

Die Lager nach Anspruch 3 können z.B. als an der Positioniereinheit angebrachte Laufrollen ausgebildet sein, die sich an den schienenartigen Führungsbahnen nach Anspruch 4 abstützen und deren Drehachse die Gelenkachse bildet.

Die Lager können aber auch als relativ zur Verbindungsachse kurze Führungselemente in der Art von linearen Kugelumlaufelementen nach Anspruch 5 ausgebildet sein. Bei biegesteifer Anbindung an die Positioniereinheit entsteht zwar zu den Führungsbahnen eine geringfügige Verkantung, die jedoch durch die elastische Nachgiebigkeit der Wälzkörper ausgeglichen wird, so dass hier die Gelenkachse im Zentrum des Lagers liegt. Da die üblichen Kugelumlaufführungen zweidimensional formschlüssig und unter Vorspannung an den z.B. schienenartigen Führungsbahnen anliegen, wird trotz der geringen Führungslänge ein Tordieren oder Verdrehen der Positioniereinheit um die Verbindungsachse verhindert.

Durch die Verlagerung der Gelenkachsen nach Anspruch 6 in die einander abgewandten Lagerenden wird die Winkelabweichung der Verbindungsachse von der orthogonalen Querrichtung zu den Führungsbahnen vergrößert, was eine stabilere Abstützung der Positioniereinheit ermöglicht.

Das erfindungsgemäße 2-Punkt Führungsprinzip kann besonders vorteilhaft auf einen länglichen trägerartigen Positionierarm nach den Ansprüchen 7 und 8 angewendet werden.

Der in den Führungsbahnen verschiebbare Positionierarm nach Anspruch 9 bildet eine schwingungsarme erste Achse und die Führung mit der darin verschiebbaren Funktionseinheit die zweite Achse eines zweidimensionalen Positioniersystems. Aufgrund der beidseitigen Einspannung kann der Positionierarm relativ schlank und leicht ausgebildet werden, so dass er besonders vorteilhaft bei hochgenauen und/oder hochdynamischen Anwendung insbesondere in der Elektronikfertigung eingesetzt werden kann.

Die Weiterbildung nach den Ansprüchen 10 und 11 ergibt die zueinander schiefwinkeligen Koordinatenrichtungen des diagonalen Positioniersystems, bei dem die Positionierdaten durch eine einfache Transformation der vorgegebenen Zieldaten vorab oder während des Betriebs errechnet werden können. Ein solches Positioniersystem mit dem schlanken Positionierarm kann besonders raumsparend ausgebildet und betrieben werden.

Die Weiterbildung nach den Ansprüchen 12 und 13 ermöglicht es, ungeachtet des diagonal geführten Positionierarms die Funktionseinheit orthogonal zu betreiben.

Der Verschiebeantrieb nach Anspruch 14 kann z.B. außerhalb auf einer Außenseite einer der Führungsbahnen angeordnet werden, ohne den Funktionsbereich der Positioniereinrichtung zu verengen.

Mit den Positionierhilfen nach Anspruch 15 lässt sich der Positionierarm präzise steuern, wobei mit Hilfe der Zentriermarke eine z.B. durch Wärmedehnung bedingte Winkeländerung erfasst und berücksichtigt werden kann.

Wegen des geringen Führungs- und Fertigungsaufwandes eignet sich das erfindungsgemäße 2-Punkt Führungsprinzip auch zum Führen einer kompakten Positioniereinheit nach den Ansprüchen 16 und 17, z.B. eines Bestückkopfes entlang dem erfindungsgemäßen oder auch entlang einem herkömmlichen Positionierarm.

Ein Ausführungsbeispiel der Erfindung ist in der Zeichnung dargestellt und wird im Folgenden näher erläutert. Es zeigen:
- Figur 1: eine schematisierte Draufsicht auf eine Vorrichtung zum Bestücken von Substraten mit elektrischen Bauelementen,
- Figur 2: einen Teil einer abgewandelten Bestückvorrichtung nach Figur 1,
- Figur 3: eine schematisierte Seitenansicht einer anderen Bestückvorrichtung,
- Figur 4: eine Draufsicht auf die Bestückvorrichtung nach Figur 3,
- Figur 5: eine schematisierte Draufsicht auf einen Teil einer weiteren Bestückvorrichtung

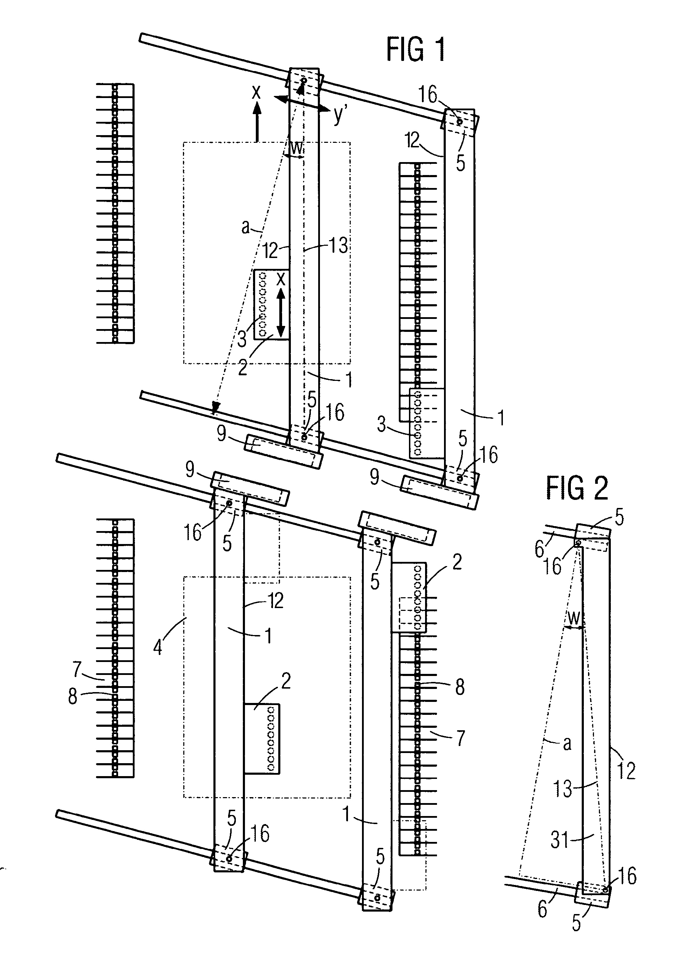

Figur 1 zeigt die wesentlichen Funktionseinheiten einer Bestückvorrichtung mit zwei in der Transportrichtung x hintereinanderliegenden Bestückfeldern für Substrate 4 und mit seitlich davon angeordneten Bauelementezuführungen 7, die in der Transportrichtung x aneinander gereihte Abholstellen 8 für Bauelemente 14 aufweisen.

Über den beiden Bestückfeldern und den Abholstellen 8 sind je zwei längliche, in der Transportrichtung x orientierte erste Positionierarme 1 in zueinander parallelen stationären Führungsbahnen 6 mittels je eines Spulenteils 9 eines Linearmotors verfahrbar. Die schienenartigen Führungsbahnen 6 erstrecken sich diagonal zur Transportrichtung in einer ersten Querrichtung y'. Der erste Positionierarm 1 ist an beiden Enden mit je einem Lager 5 in einer der schienenartigen Führungsbahnen 6 spielfrei geführt.

Die z.B. als Kugelumlaufelemente ausgebildeten Lager 5 haben im Verhältnis zum Abstand zwischen den Führungsbahnen 6 eine kurze Führungslänge und bilden aufgrund ihrer Eigenelastizität in ihrem Zentrum und damit über der Bahnenmitte eine senkrechte Gelenkachse 16 zwischen den Lagern 5 und den Führungsbahnen 6. Eine Verbindungsachse 13 zwischen den beiden Gelenkachsen 16 ist länger als der orthogonale Abstand a zwischen den Führungsbahnen 6, so dass die Verbindungsachse 13 unter dem Anstellwinkel w schräg zu den Führungsbahnen 6 verläuft. Durch die schräge Überschneidung mit den Führungsbahnen 6 können an den Gelenken auch quer zur Verbindungsachse gerichtete Kraftkomponenten auftreten, so dass der erste Positionierarm 1 auch in seiner Querrichtung gegen Auslenkung und entsprechende Schwingungen gesichert ist.

Bei dem gestreckt verlaufenden ersten Positionierarm 1 mit einer längsseitigen Führung 12 für einen Bestückkopf 2 zum Handhaben der Bauelemente 14 können die Führungsbahnen 6 schräg zur Transportrichtung x der Substrate 4 derart ausgerichtet werden, dass der erste Positionierarm 1 parallel zur Transportrichtung der Substrate 4 steht und der Bestückkopf 2 bei stehendem ersten Positionierarm 1 über den Abholstellen 8 der Bauelementezuführung 7 verfahren kann. Bei diesem Positioniersystem können die Maschinenkoordinaten von Sauggreifern 3 für die Bauelemente 14 auf die Zielkoordinaten der Bauelemente vorab umgerechnet werden. Durch den schlanken ersten Positionierarm 1 verringert sich die Breite der Bestückvorrichtung. Pro Bestückfeld können wie üblich auf einer Führung zwei der ersten Positionierarme 1 angeordnet werden.

Nach Figur 2 ist ein abgewandelter zweiter Positionierarm 31 mit den Lagern 5 über Gelenke verbunden, wobei die Gelenkachsen 16 außerhalb der Lagermitte in den einander entgegengesetzten Eckbereichen der Lager 5 angeordnet sind. Dadurch verläuft bei dem in der Transportrichtung x orientierten zweiten Positionierarm 31 die Verbindungsachse 13 schräg zur Transportrichtung x bzw. zur Führung 12. Bei gleichbleibendem Winkel w erstrecken sich somit die Führungsbahnen 6 entsprechend weniger schräg zur Transportrichtung x.

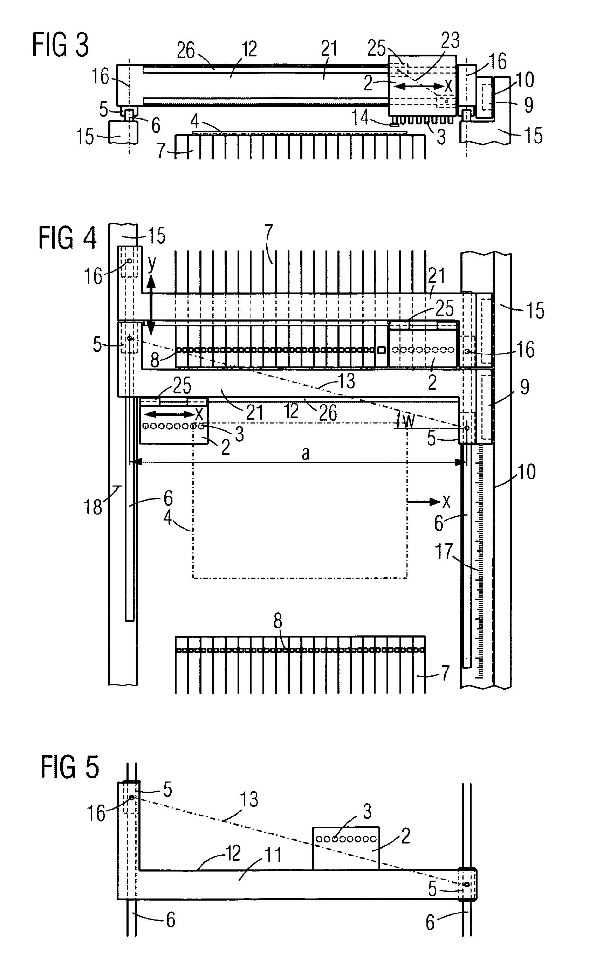

Nach den Figuren 3 und 4 sind dritte Positionierarme 21 z-förmig verlaufend ausgebildet mit kurzen Seitenschenkeln an beiden Enden, den kurzen Lagern 5 an den freien Enden der Seitenschenkel und den zentralen Gelenkachsen 16. Der Abstand zwischen den Gelenkachsen 16 ist hier ebenfalls größer als der orthogonale Abstand a zwischen den Führungsbahnen 6 und entspricht dem Anstellwinkel w der Verbindungsachse 13. Die Führungsbahnen 6 sind auf einem Chassis 15 der Bestückvorrichtung befestigt und erstrecken sich in einer orthogonalen zweiten Querrichtung y senkrecht zur Transportrichtung x. Die beiden Bereiche der Bauelementezuführungen 7 sind demgemäß ohne seitlichen Versatz in der Querrichtung y hintereinanderliegend angeordnet. Der dritte Positionierarm 21 ist darin in der zweiten Querrichtung y verschiebbar geführt. Die Führung 12 für den Bestückkopf 2 erstreckt sich parallel zur Transportrichtung x und senkrecht zu den Führungsbahnen 6, die senkrecht zur Transportrichtung x ausgerichtet sind, so dass das übliche orthogonale Positioniersystem beibehalten werden kann.

Ein solcher Positionierarm kann in der Draufsicht z.B. dreieckförmig oder, wie dargestellt, massearm Z-förmig verlaufend ausgebildet sein mit der Führung 12 am mittleren Schenkel. Ein aus dem mobilen Spulenteil 9 und einer stationären Magnetbahn 10 gebildeter Linearmotor ist an einem der beiden Enden des dritten Positionierarmes 21 angeordnet und bewegt diesen in der zweiten Querrichtung y. Die Z-Form ergibt knicksteife Positionierarme mit einer gemeinsamen Magnetbahn 10 für beide Spulenteile 9. Neben der benachbarten Führungsbahn 6 ist auf dem Chassis 15 ein Längenmaßstab 17 fixiert, mit dem die y-Position der Positionierarme 21 bestimmt werden kann. Neben der anderen Führungsbahn 6 ist eine Zentriermarke 18 angebracht, mit der eine z.B. durch thermischen Verzug bewirkte Änderung des Anstellwinkels w überwacht werden kann.

Die Führung 12 ist hier durch zwei andere Führungsbahnen 26 gebildet, die sich entlang einer senkrechten Seitenwand des mittleren Schenkels mit Abstand parallel übereinander erstrecken. Der Bestückkopf 2 ist mit zwei anderen Lagern 25 versehen, die in der x-Richtung zueinander soweit versetzt sind, dass ihre Verbindungsachse 23 unter ca. 45° schräg zur X-Richtung verläuft. Ein zwischen den Lagern 25 angeordneter nicht dargestellter Linearmotor kann zwischen den Führungsbahnen 26 und den Lagern 25 zu thermisch bedingtem Versatz führen, der durch die diagonale Lageranordnung abgefangen werden kann. Eine solche Führung kann nicht nur an dem erfindungsgemäßen, sondern auch an einem konventionellen Positionierarm ausgebildet sein.

Figur 5 zeigt ein ähnliches orthogonales Positioniersystem wie Figur 3, bei dem jedoch ein vierter Positionierarm 11 L-förmig verlaufend ausgebildet ist. Der vierte Positionierarm 11 weist somit nur einen verlängerten Seitenschenkel 23 auf. Die Führung 12 für den Bestückkopf 2 befindet sich hier auf der dem Seitenschenkels 23 zugewandten Seite des Hauptschenkels, so dass der Bestückkopf 2 nahe an der Verbindungsachse 13 angeordnet ist.

### Bezugszeichen

- a: Abstand
- x: Transportrichtung
- w: Anstellwinkel
- y': erste Querrichtung
- y: zweite Querrichtung
- 1: erster Positionierarm
- 2: Bestückkopf
- 3: Sauggreifer
- 4: Substrat
- 5: Lager
- 6: Führungsbahn
- 7: Bauelementezuführung
- 8: Abholstelle
- 9: Spulenteil
- 10: Magnetbahn
- 11: vierter Positionierarm
- 12: Führung
- 13: Verbindungsachse
- 14: Bauelement
- 15: Chassis
- 16: Gelenkachse
- 17: Längenmaßstab
- 18: Zentriermarke
- 21: dritter Positionierarm
- 23: Verbindungsachse
- 25: Lager
- 26: Führungsbahn
- 31: zweiter Positionierarm

## Patentansprüche

1. Positioniereinrichtung, insbesondere zum Handhaben von elektrischen Bauelementen (14), mit zwei zueinander parallelen, eine Führungsebene definierenden Führungsbahnen (6) und daran linear verschiebbar geführten Lagern (5), an denen eine Positioniereinheit verankert ist,
**dadurch gekennzeichnet, dass** die Positioniereinheit im Bereich der Lager (5) an den beiden Führungsbahnen (6) um jeweils eine zur Führungsebene senkrechte Gelenkachse (16) schwenkbar gelagert ist und
dass eine Verbindungsachse (13) zwischen den Gelenkachsen (16) schräg zu den Führungsbahnen (6) verläuft.

2. Positioniereinrichtung nach Anspruch 1,
**dadurch gekennzeichnet, dass** die Gelenkachsen (16) durch elastisch nachgiebige Teile, insbesondere in der Art von Festkörpergelenken gebildet sind.

3. Positioniereinrichtung nach Anspruch 1 oder 2,
**dadurch gekennzeichnet, dass** die Lager (5) eine im Verhältnis zur Verbindungsachse (13) kurze Führungslänge aufweisen.

4. Positioniereinrichtung nach Anspruch 1, 2 oder 3,
**dadurch gekennzeichnet, dass** die Führungsbahn (6) schienenartig ausgebildet ist und dass die Lager (5) daran beidseitig anliegende Wälzkörper aufweisen.

5. Positioniereinrichtung nach Anspruch 4,
**dadurch gekennzeichnet, dass** die Lager (5) als lineare Kugelumlaufelemente ausgebildet sind.

6. Positioniereinrichtung nach Anspruch 4 oder 5,
**dadurch gekennzeichnet, dass** die Gelenkachsen 16 durch Gelenke gebildet und außerhalb der Lagermitte, insbesondere an den in der Verschieberichtung einander abgewandten Lagerenden angeordnet sind.

7. Positioniereinrichtung nach einem der Ansprüche 1 bis 6,
**dadurch gekennzeichnet, dass** die Positioniereinheit als sich zwischen den Lagern (5) erstreckender Positionierarm (1, 11, 21, 31) ausgebildet ist.

8. Positioniereinrichtung nach Anspruch 7,
**dadurch gekennzeichnet, dass** die Verbindungsachse (13) in einem Winkel von 65 bis 85° zu den Führungsbahnen verläuft.

9. Positioniereinrichtung nach Anspruch 6 oder 8,
**dadurch gekennzeichnet, dass** der Positionierarm (1, 11, 21, 31) mit einer sich quer zu den Führungsbahnen (6) erstreckenden Führung (12) für eine Funktionseinheit versehen ist, die vorzugsweise als Bestückkopf (2) zum Bestücken von Substraten mit den elektrischen Bauelementen (14) dient.

10. Positioniereinrichtung nach Anspruch 9,
**dadurch gekennzeichnet, dass** sich die Führung (12) annähernd parallel zur Verbindungsachse (13) erstreckt.

11. Positioniereinrichtung nach Anspruch 10,
**dadurch gekennzeichnet, dass** sich ein schlanker erster und zweiter Positionierarm (1, 31) im Wesentlichen in der Richtung der Verbindungsachse (13) erstreckt

12. Positioniereinrichtung nach Anspruch 9,
**dadurch gekennzeichnet, dass** sich die Führung (12) im Wesentlichen senkrecht zu den Führungsbahnen (6) und schräg zur Verbindungsachse (13) erstreckt.

13. Positioniereinrichtung nach Anspruch 12,
**dadurch gekennzeichnet, dass** ein dritter und vierter Positionierarm (11, 21) zwischen den Lagern (5) L- oder Z-förmig verlaufend ausgebildet ist.

14. Positioniereinrichtung nach einem der vorhergehenden Ansprüche,
**dadurch gekennzeichnet, dass** ein insbesondere als Linearmotor (9, 10) ausgebildeter Verschiebantrieb für die Positioniereinheit in der Nähe einer der Führungsbahnen (6) angeordnet ist.

15. Positioniereinrichtung nach einem der vorhergehenden Ansprüche,
**dadurch gekennzeichnet, dass** die Positioniereinrichtung entlang einer der Führungsbahnen (6) einen Längenmaßstab (17) und an der anderen Führungsbahn (6) einen weiteren Längenmaßstab oder eine Zentriermarke aufweist.

16. Positioniereinrichtung nach einem der vorhergehenden Ansprüche,
**dadurch gekennzeichnet, dass** andere Führungsbahnen (26) an einem mobilen Träger, insbesondere am Positionierarm (21) ausgebildet sind und dass die Positioniereinheit mit den an den anderen Führungsbahnen (26) verschiebbaren diagonalen Lagern (25) als Positionierkopf, insbesondere in Form des Bestückkopfes (2) dient.

17. Positioniereinrichtung nach Anspruch 16, **dadurch gekennzeichnet, dass** die Verbindungsachse (23) zwischen den Gelenkachsen am kompakten Positionierkopf ungefähr im Winkel von 45° zu den Führungsbahnen (26) verläuft.

## Claims

1. Positioning device, especially for handling electrical components (14), with two guide tracks (6) parallel to each other defining a guide plane and bearings (5), guided on said tracks to allow linear movement, on which a positioning unit is anchored,
**characterised in that** the positioning unit is supported in the area of the bearings (5) on the two guide tracks (6) around a pivot axis (16) perpendicular to the direction of guidance in each case and
that a connecting axis (13) between the pivot axes (16) runs at an angle to the guide tracks (6).

2. Positioning device according to claim 1,
**characterised in that** the pivot axes (16) are formed by elastically flexible parts, especially in the form of fixed-body joints.

3. Positioning device according to claim 1 or 2,
**characterised in that** the bearings (5) have a short guide length in relation to the connection axis (13).

4. Positioning device according to claim 1, 2 or 3,
**characterised in that** the guide track (6) is embodied in the form of a rail and that the bearings (5) have roller bearings in contact with both sides of said rail.

5. Positioning device according to claim 4,
**characterised in that** the bearings (5) are embodied as linear orbital elements.

6. Positioning device according to claim 4 or 5,
**characterised in that** the pivot axes 16 are formed by joints and are arranged outside the centre of the support, especially at the ends of the support facing away from each other in the direction of movement.

7. Positioning device according to one of the claims 1 to 6,
**characterised in that** the positioning unit is embodied as a positioning arm (1, 11, 21, 31) extending between the bearings (5).

8. Positioning device according to claim 7,
**characterised in that** the connecting axis (13) runs at an angle of 65° to 85° to the guide tracks.

9. Positioning device according to claim 6 or 8,
**characterised in that** that the positioning arm (1, 11, 21, 31) is provided with a guide (12) extending at an angle to the guide tracks (6) for a functional unit, which preferably serves as loading head (2) for loading substrates with the electrical components (14).

10. Positioning device according to claim 9,
**characterised in that** the guide (12) extends almost in parallel to the connection axis (13).

11. Positioning device according to claim 10,
**characterised in that** a narrower first and second positioning arm (1, 31) extends essentially in the direction of the connecting axis (13).

12. Positioning device according to claim 9,
**characterised in that** the guide (12) essentially extends perpendicular to the guide tracks (6) and at an angle to the connection axis (13).

13. Positioning device according to claim 12,
**characterised in that** a third and fourth positioning arm (11, 21) is embodied running between the bearings (5) in an L-shape or Z-shape.

14. Positioning device according to one of the previous claims,
**characterised in that** a movement drive especially embodied as a linear motor (9, 10), is arranged for the positioning unit in the vicinity of one of the guide tracks (6).

15. Positioning device according to one of the previous claims,
**characterised in that** the positioning device has a length scale (17) along one of the guide tracks (6) and on the other guide track (6) has a further length scale or a centring mark.

16. Positioning device according to one of the previous claims,
**characterised in that** other guide tracks (26) are embodied on a mobile carrier, especially on the positioning arm (21) and that the positioning unit with diagonal supports (25) movable on the other guide tracks (26) serves as a positioning head, especially in the form of a loading head (2).

17. Positioning device according to claim 16,
**characterised in that** the connecting axis (23) between the pivot axes on the compact positioning head runs approximately at an angle of 45° to the guide tracks (26).

## Revendications

1. Dispositif de positionnement, en particulier pour la manipulation de composants (14) électriques, comprenant deux bandes de guidage (6) parallèles entre elles et définissant un plan de guidage et des paliers (5) guidés dessus de sorte à pouvoir coulisser linéairement, sur lesquels est ancrée une unité de positionnement,
**caractérisé en ce que** l'unité de positionnement est logée dans la zone au niveau des paliers (5) sur les deux bandes de guidage (6) de façon à pouvoir basculer autour de respectivement un axe d'articulation (16) perpendiculaire au plan de guidage et **en ce qu'**un axe de liaison (13) est agencé en biais par rapport aux bandes de guidage (6) entre les axes articulés (16).

2. Dispositif de positionnement selon la revendication 1,
**caractérisé en ce que** les axes d'articulation (16) sont formés par des parties élastiquement flexibles, en particulier à la façon d'articulations de corps solide.

3. Dispositif de positionnement selon la revendication 1 ou 2,
**caractérisé en ce que** les paliers (5) présentent une longueur de guidage courte par rapport à l'axe de liaison (13).

4. Dispositif de positionnement selon la revendication 1, 2 ou 3,
**caractérisé en ce que** la bande de guidage (6) est réalisée à la façon d'un rail et **en ce que** les paliers (5) présentent des corps de roulement s'appliquant dessus sur les deux côtés.

5. Dispositif de positionnement selon la revendication 4,
**caractérisé en ce que** les paliers (5) sont conçus comme des éléments linéaires à recirculation de billes.

6. Dispositif de positionnement selon la revendication 4 ou 5,
**caractérisé en ce que** les axes d'articulation (16) sont formés par des articulations et sont disposés à l'extérieur du centre de palier, en particulier sur les extrémités de palier opposées les unes aux autres dans le sens de coulissement.

7. Dispositif de positionnement selon l'une quelconque des revendications 1 à 6,
**caractérisé en ce que** l'unité de positionnement est conçue comme un bras de positionnement (1, 11, 21, 31) s'étendant entre les paliers (5).

8. Dispositif de positionnement selon la revendication 7,
**caractérisé en ce que** l'axe de liaison (13) est agencé dans un angle de 65 à 85° par rapport aux bandes de guidage.

9. Dispositif de positionnement selon la revendication 6 ou 8,
**caractérisé en ce que** le bras de positionnement (1, 11, 21, 31) est doté d'un guide (12) s'étendant transversalement aux bandes de guidage (6) pour une unité de fonction, qui sert de préférence de tête d'équipement (2) pour l'équipement de substrats avec les composants (14) électriques.

10. Dispositif de positionnement selon la revendication 9,
**caractérisé en ce que** le guide (12) s'étend approximativement parallèlement à l'axe de liaison (13).

11. Dispositif de positionnement selon la revendication 10,
**caractérisé en ce qu'**un premier bras de positionnement élancé et un second bras de positionnement (1, 31) s'étendent essentiellement dans la direction de l'axe de liaison (13).

12. Dispositif de positionnement selon la revendication 9,
**caractérisé en ce que** le guide (12) s'étend essentiellement perpendiculairement aux bandes de guidage (6) et en biais par rapport à l'axe de liaison (13).

13. Dispositif de positionnement selon la revendication 12,
**caractérisé en ce qu'**un troisième et un quatrième bras de positionnement (11, 21) sont réalisés entre les paliers (5) en forme de L ou de Z.

14. Dispositif de positionnement selon l'une quelconque des revendications précédentes,
**caractérisé en ce qu'**un entrainement de coulissement pour l'unité de positionnement, conçu en particulier comme un moteur linéaire (9, 10), est disposé à proximité de l'une des bandes de guidage (6).

15. Dispositif de positionnement selon l'une quelconque des revendications précédentes,
**caractérisé en ce que** le dispositif de positionnement présente une échelle de longueur (17) le long de l'une des bandes de guidage (6) et une autre échelle de longueur ou un repère de centrage sur l'autre bande de guidage (6).

16. Dispositif de positionnement selon l'une quelconque des revendications précédentes,
**caractérisé en ce que** d'autres bandes de guidage (26) sont réalisées sur un support mobile, en particulier sur le bras de positionnement (21) et **en ce que** l'unité de positionnement avec les paliers (25) diagonaux, pouvant coulisser sur les autres bandes de guidage (26), sert de tête de positionnement, en particulier sous la forme de la tête d'équipement (2).

17. Dispositif de positionnement selon la revendication 16,
**caractérisé en ce que** l'axe de liaison (23) est agencé approximativement dans un angle de 45° par rapport aux bandes de guidage (26) entre les axes d'articulation sur la tête de positionnement compacte.
